# FASCICULE DE BREVET EUROPEEN

(11) **EP 4 575 512 B1**
(45) Date de publication et mention de la délivrance du brevet: **04.11.2026**
(21) Numéro de dépôt: 24220685.2
(22) Date de dépôt: 17.12.2024
(51) Int. Cl.: G01P 5/08, G01F 1/58, G01F 1/60

(54) **DÉTECTEUR DE VARIATION DE VITESSE D'UN ÉCOULEMENT DE FLUIDE ÉLECTRIQUEMENT CONDUCTEUR, COMPRENANT UN TRANSDUCTEUR ÉLECTROMAGNÉTIQUE**
DETEKTOR ZUR BESTIMMUNG DER GESCHWINDIGKEITSÄNDERUNG EINES ELEKTRISCH LEITENDEN FLUIDSTROMS MIT EINEM ELEKTROMAGNETISCHEN WANDLER
DETECTOR FOR DETECTING THE SPEED VARIATION OF AN ELECTRICALLY CONDUCTIVE FLUID FLOW, COMPRISING AN ELECTROMAGNETIC TRANSDUCER

(30) Priorité: 19.12.2023 FR 2314457
(43) Date de publication de la demande: 25.06.2025
(73) Titulaire: Commissariat à l'Energie Atomique et aux Energies Alternatives, 75015 Paris (FR)
(72) Inventeur: REY, Frédéric, 13115 SAINT PAUL LEZ DURANCE (FR)
(74) Mandataire: Ipsilon

(56) Documents cités:
- DE-A1- 102006 018 623
- DE-A1- 102014 002 392
- DE-A1- 102020 131 685

## Description

### Domaine technique

La présente invention concerne le domaine de l'instrumentation et de la mesure, et plus particulièrement celui des transducteurs dédiés à la vélocimétrie locale, ponctuelle, des fluides conducteurs de l'électricité.

L'invention porte sur un détecteur de variation de vitesse d'un fluide conducteur électrique comprenant un transducteur électromagnétique.

L'invention s'applique de manière générale à tout fluide conducteur de l'électricité. Ces fluides sont par exemple les solutions ioniques conductrices de l'électricité comme l'eau salée et plus encore les métaux liquides. Usuellement, ces métaux sont par exemple le sodium, le potassium, le plomb, le lithium, l'aluminium, le cuivre, le fer, le zinc, le titane et leurs alliages.

Plus particulièrement, l'invention s'applique à des mesures dans des fluides de type liquides denses ayant une masse volumique dans une plage de l'ordre de 100 kg.m⁻³ à plus de 10000kg.m⁻³.

L'invention est particulièrement adaptée pour des mesures de vitesses de fluides dont la gamme de températures de fusion est la plage des températures de fusion des métaux traités, mis en forme ou utilisés sous forme liquide, typiquement d'environ -50 °C à plus de 1500°C.

Une application avantageuse envisagée est la mesure de vitesses de caloporteurs, notamment des réacteurs nucléaires de fission et de fusion.

### Technique antérieure

Dans de nombreuses applications, il est nécessaire de connaître le champ de vitesse d'un fluide conducteur de l'électricité, en mouvement.

C'est le cas dans l'industrie de la fonderie métallique où la connaissance du champ des vitesses dans les moules de fonderies et leurs circuits d'alimentation permet de prévoir la qualité des pièces produites et limiter les rebus. La connaissance des vitesses d'écoulement permet en effet de contrôler et optimiser le remplissage des moules de fonderie.

Dans l'industrie nucléaire, le champ des vitesses des caloporteurs métalliques utilisés dans les circuits de certains réacteurs nucléaires est un facteur majeur dans la sollicitation des structures métalliques au contact. Aussi, sa connaissance est primordiale.

C'est également un facteur majeur des échanges thermiques existant dans les échangeurs de chaleur et au niveau du combustible nucléaire de ces réacteurs.

La connaissance et l'analyse du champ des vitesses dans les endroits clés d'un réacteur (échangeurs de chaleur, sortie de cœur, pompe, etc..) est également un indicateur de bon fonctionnement et donc, un moyen d'accroître la sûreté et globalement les possibilités de surveillance de ces machines.

Les expériences scientifiques mettant en œuvre des métaux liquides dans des volumes de grandes dimensions, ainsi que les essais réalisés dans la perspective de connaître des distributions d'écoulement dans des collecteurs d'échangeurs, nécessitent également de connaître le champ des vitesses des écoulements en jeu.

Dans les différentes zones d'écoulement citées, les conditions d'écoulement sont tridimensionnelles. Ce qui caractérise aussi le plus souvent ces écoulements est leur niveau de température, le plus souvent de plusieurs centaines de degrés, et la masse volumique des fluides utilisés dont la gamme peut s'étendre de quelques centaines de kg.m⁻³ à plusieurs milliers de kg.m⁻³

Différentes techniques de vélocimétrie sont connues et utilisées pour mesurer les composantes de vitesse d'un écoulement de liquide conducteur de l'électricité.

Parmi celles-ci, les techniques électromagnétiques sont particulièrement pertinentes et robustes, en termes de tenue des matériaux, aux sollicitations qui lui sont appliquées par l'environnement dans lequel la mesure doit être réalisée. Ces techniques sont d'autant plus intéressantes s'il s'agit d'un fluide dense et chimiquement réactif, comme les métaux liquides.

Le document DE 10 2006 018623 A1 décrit un détecteur destiné à détecter les variations de vitesse d'un écoulement d'un fluide électriquement conducteur, qui comprend un transducteur électromagnétique avec un tube cylindrique, une bobine d'excitation électrique située le long du tube, alimentée en courant alternatif et comportant un noyau à haute perméabilité magnétique, et une bobine de réception électrique située le long du tube en face de la bobine primaire.

Le principe de fonctionnement des transducteurs électromagnétiques est illustré par l'expression de la loi d'Ohm dans le fluide en mouvement soumis à un champ magnétique. Elle montre que la conductivité *σ* du fluide entraîne le développement de courants (densité de courant électrique J) sous l'action de la vitesse de déplacement u conjuguée au champ magnétique externe B : [Equation 1] $\vec{{J}_{u}} = σ \left(\vec{E}+\vec{u}\times \vec{B}\right)$

Cela se produit même en l'absence de champ électrique E.

Les densités de courants *Jᵤ* sont source d'un champ magnétique *Bᵤ.* Ce champ *Bᵤ* déforme le champ externe *B*.

On précise ici que, par simplification, le vecteur symbolisé par la lettre B, qui est la densité de flux magnétique ou induction magnétique, est désigné dans l'ensemble de la demande sous l'appellation de champ magnétique. On précise également que les différentes formulations indiquées plus loin, sont écrites dans le cadre de l'approximation des régimes quasi-permanents, permettant de négliger certaines grandeurs intervenant dans les équations de Maxwell, comme les courants de déplacement.

A ce jour, les mesures d'une seule composante de vitesse d'un écoulement sont couramment réalisées par des transducteurs électromagnétiques, désignés couramment sous l'acronyme DDF pour « Débitmètre à Distorsion de Flux », ou celui anglo-saxon ECFM (« Eddy Current Flow Meter ») ou encore PSFM (« Phase Shift Flow Meter »).

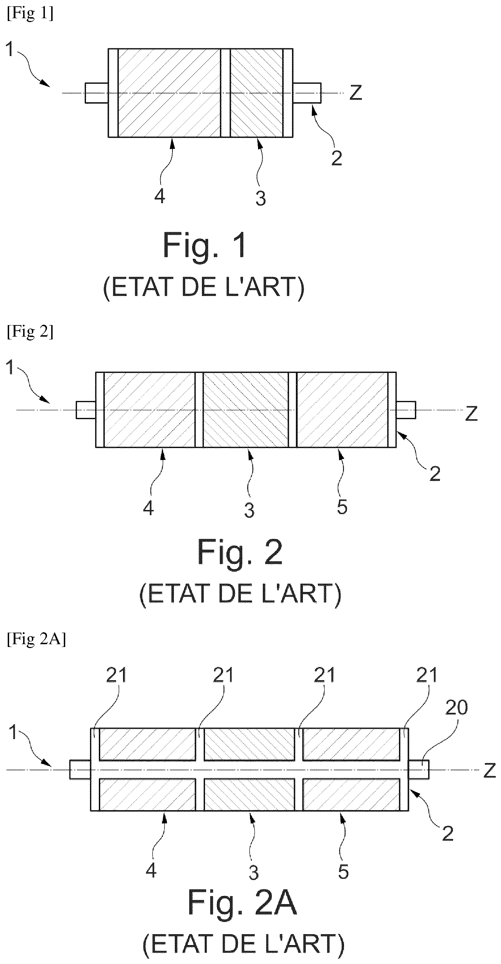

Un DDF classique, globalement désigné par la référence 1 est montré aux figures 1, 2 et 2A : il est axisymétrique d'axe central Z et typiquement constitué d'un noyau 2, d'une bobine électrique émettrice, dite primaire 3, et d'une ou de deux bobines électriques réceptrices, dites secondaires 4, 5. Le noyau 2 est formé d'une tige pleine 20 s'étendant selon l'axe central Z et de disques pleins 21 régulièrement espacés selon l'axe central (X), la tige pleine reliant les disques pleins entre eux. Les bobines primaire 3 et secondaires 4, 5 sont enroulées autour de la tige pleine 20 entre deux des disques pleins 21.

Un courant électrique alternatif est imposé dans la bobine primaire. La circulation de ce courant crée un champ magnétique externe *B* dans l'environnement proche de la bobine primaire, selon l'équation de Maxwell - Ampère : [Equation 2] $\vec{∇} \times \vec{B} = μ . \vec{J}$ avec :
*̅∇̅*̅ : opérateur différentiel
*µ* : perméabilité magnétique avec *µ* = *µᵣµ*₀
*µ*₀ : perméabilité magnétique du vide
*B* : traverse les bobines réceptrices.

Le courant primaire est alternatif, de manière à ce que *B* soit alternatif également. De la sorte *B* induit une tension électrique dans chacune des bobines réceptrices, selon l'équation de Maxwell - Faraday : [Equation 3] $\vec{∇} \times \vec{E} = - \frac{\partial \vec{B}}{\partial t}$ avec :
*̅E̅*̅ : champ électrique.

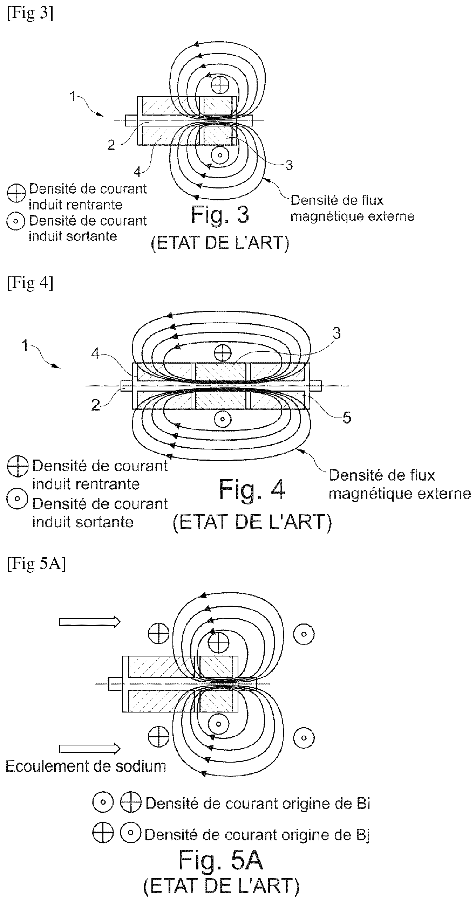

Par ailleurs, B entraîne aussi le développement de densités de courants induites Jᵢ dans le fluide, ainsi que dans tout conducteur électrique environnant soumis à ce champ magnétique, dont le métal des tubes. Les figures 3 et 4 montrent le développement de densités de courants induits sous l'action du champ magnétique externe, en l'absence de vitesse d'écoulement, pour un DDF, respectivement à une bobine secondaire 4, et à deux bobines secondaires 4, 5.

Les densités de courant Ji créent à leur tour un champ magnétique Bi déformant le champ externe B. Ainsi, le champ B n'est pas le même suivant que le DDF est entouré d'un fluide conducteur de l'électricité ou non.

En l'absence de mouvement de fluide, la ou les bobines réceptrices délivrent des tensions électriques qui sont des fonctions du champ magnétique externe B et du champ Bi.

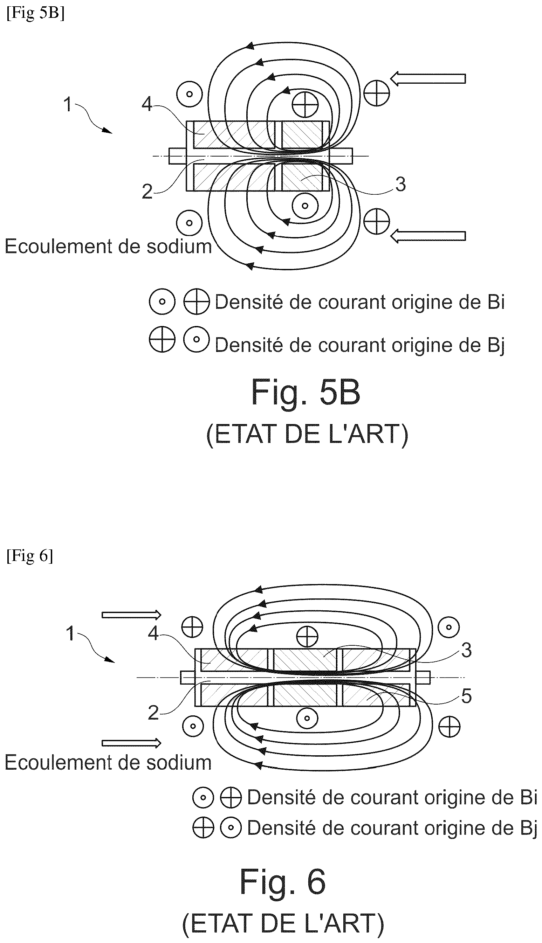

En présence d'un mouvement de fluide, de nouvelles densités de courant Ju apparaissent et sont source d'un champ magnétique Bu. Ce nouveau champ modifie B, qui est en quelque sorte soufflé par l'écoulement de fluide conducteur et se déforme dans le sens de l'écoulement de celui-ci, comme illustré aux figures 5A, 5B et 6.

Le flux magnétique passant à travers la ou les bobines réceptrices dépend de la vitesse d'écoulement.

La ou les bobines réceptrices délivrent donc des tensions électriques traduisant l'influence des champs magnétiques *Bᵢ* et *Bᵤ* qui déforment le champ externe *B.*

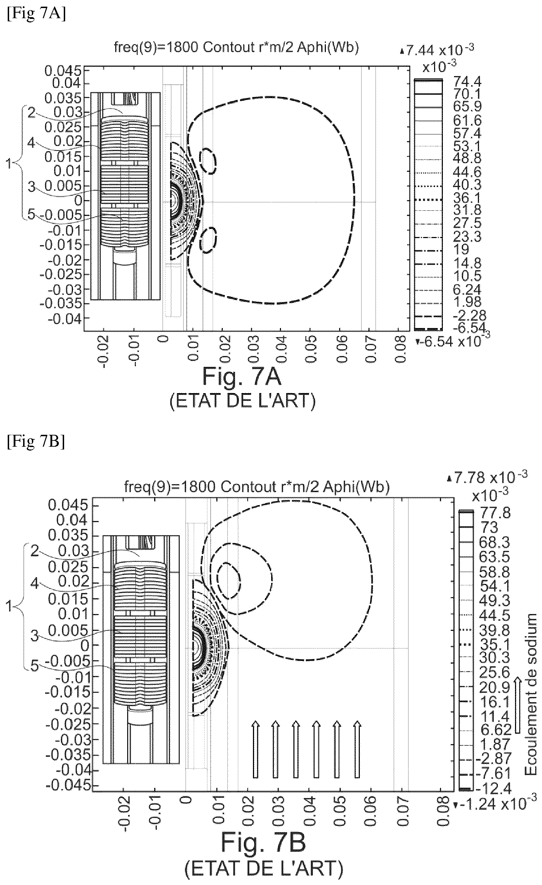

Des simulations numériques illustrent cela. Les figures 7A et 7B sont des simulations numériques du champ magnétique autour d'un DDF respectivement en l'absence et en présence de vitesse d'écoulement de fluide conducteur de l'électricité.

L'analyse des tensions électriques délivrées par les bobines réceptrices permet de déterminer la vitesse d'écoulement du fluide en mouvement dans la zone d'action du champ magnétique B.

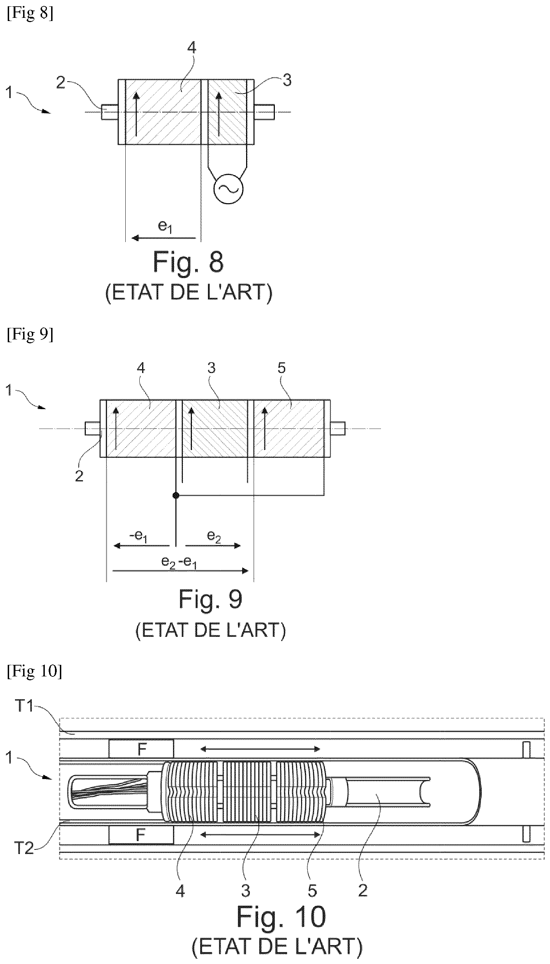

Comme montré à la figure 8, si la bobine réceptrice unique 4 d'un DDF 1 est en amont par rapport au sens de l'écoulement de fluide, elle voit une baisse de flux magnétique quand la vitesse augmente (et inversement). La tension alternative *e₁* qu'elle délivre décroît de *Δe₁.*

La tension alternative *e₁* fournie par le DDF est l'image de la vitesse d'écoulement (avec indication du sens relativement grâce à la comparaison de l'amplitude du signal courant avec l'amplitude du signal sans vitesse).

En plus de cela, dans le cas d'un DDF à deux bobines réceptrices, la bobine réceptrice aval voit une augmentation du flux qui la traverse alors que la vitesse de fluide augmente. Sa tension *e₂* croît de *Δe₂*. $On a \left|{Δe}_{2}\right| = \left|{Δe}_{1}\right|$

Généralement, les deux bobines réceptrices 4, 5 d'un DDF sont électriquement couplées en anti-série, comme montré à la figure 9.

De cette manière, le signal V fourni par le DDF à deux bobines est donné par : $V = \left|{e}_{2}\right| - \left|{e}_{1}\right|$ avec |*eₓ*| : module ou amplitude de la tension *eₓ.*

Le signal *V* est proportionnel à la composante de vitesse de l'écoulement projetée sur l'axe de révolution du DDF.

En pratique, on privilégie le DDF à deux bobines réceptrices, car l'utilisation combinée des tensions délivrées par ces deux bobines permet de doubler la sensibilité et supprimer la dépendance de la réponse du DDF à des grandeurs non pertinentes comme la température : $V = \left(\left|{e}_{2}\right|-\left|{e}_{1}\right|\right) / \left(\left|{e}_{2}\right|+\left|{e}_{1}\right|\right)$

Le signe de *V* donne le sens de la vitesse sans nécessité de comparaison avec l'amplitude du signal sans vitesse d'écoulement.

En ce qui concerne l'agencement des DDF relativement à l'écoulement de fluide, ils peuvent être internes à l'écoulement, c'est-à-dire positionnés sur l'axe d'un tube au milieu de l'écoulement à caractériser : [1]. Un DDF est ainsi au sein de l'écoulement de fluide, celui-ci étant périphérique au DDF.

En pratique, comme montré à la figure 10, un DDF interne 1 est généralement placé au centre d'un espace annulaire, délimité par deux tubes concentriques T1, T2, dans lequel s'écoule le fluide F dont on cherche à mesurer les vitesses.

D'autres DDF peuvent être externes à l'écoulement. Les bobines et le noyau des DDF externes sont ainsi disposés autour de l'écoulement de fluide pour lequel on souhaite mesurer les vitesses.

En pratique, un DDF externe est placé autour d'un tube pour mesurer la vitesse du fluide qui s'écoule dans ce tube : [2].

Quand les DDF sont utilisés pour évaluer la vitesse d'un fluide circulant dans un tube, qu'ils soient internes ou externes à ce dernier, ils ne peuvent mesurer qu'une composante de vitesse qui est celle selon l'axe du tube et donc selon leur axe d'axisymétrie X. En effet, le tube guide l'écoulement du fluide et lui donne sa direction principale.

De manière générale, le traitement du signal d'un DDF classique ou des débitmètres actuellement existants peut être complexe à réaliser.

Il existe donc un besoin de proposer une solution simplifiée de mesure de vitesse et traitement du signal afférent, d'écoulement de fluides conducteurs de l'électricité, qui peuvent être denses, pour une gamme de vitesses élevées et/ou à des températures élevées, et ce, même dans des volumes importants.

Le but de l'invention est de répondre au moins en partie à ce besoin.

### Exposé de l'invention

Pour ce faire, l'invention a pour objet un détecteur de variation de vitesse d'un écoulement d'un fluide électriquement conducteur, comprenant :
- un transducteur électromagnétique, comprenant :
   un tube cylindrique métallique formant un noyau à haute perméabilité magnétique,
   une bobine électrique, dite bobine primaire, enroulée autour du tube et destinée à être alimentée électriquement en courant continu, ou un aimant permanent agencé autour du tube,
   au moins une bobine électrique, dite bobine réceptrice, enroulée autour du tube en étant adjacente à la bobine primaire ou à l'aimant permanent,
- au moins un circuit détecteur d'enveloppe relié à la bobine réceptrice, comprenant au moins une diode et une charge en série électrique avec la diode, la charge étant constituée d'un condensateur et d'une résistance électrique.

Selon un premier mode de réalisation, le détecteur comprend un seul circuit détecteur d'enveloppe.

De manière alternative, selon un deuxième mode de réalisation, le détecteur comprend deux circuits détecteurs d'enveloppe en parallèle à la bobine réceptrice, la diode de l'un des deux circuits étant montée en sens opposé à la diode de l'autre des deux circuits. Un détecteur selon ce mode permet d'avoir une détection à la fois de l'accroissement et de la diminution de la vitesse de l'écoulement du fluide.

Avantageusement, le détecteur comprend un dispositif électronique relié au(x) circuit(s) détecteur(s) d'enveloppe pour détecter le(s) seuil(s) de tension électrique à la sortie du(des) condensateur(s). Le dispositif électronique est de préférence une bascule de Schmitt.

De préférence, le noyau est à faible conductivité électrique pour limiter les pertes induites par l'induction magnétique variable, à savoir les pertes joules liées à la circulation du courant induit et les pertes par hystérésis.

Ainsi, l'invention consiste essentiellement en un détecteur de variation de vitesse monodirectionnelle d'un fluide électriquement qui comprend un transducteur électromagnétique qui fonctionne soit avec une bobine primaire alimentée en courant continu soit avec un aimant permanent.

Un circuit détecteur d'enveloppe est très simple en tant que dispositif du traitement du signal reçu par la bobine réceptrice.

Un détecteur selon l'invention permet de mesurer des variations de vitesse d'un fluide dont la vitesse nominale peut être de quelques millimètres par seconde à plusieurs mètres par seconde.

En outre, il est adapté pour la mesure de variations de vitesses de liquides électriquement conducteurs, qui sont denses, typiquement de densité de l'ordre de 100 à plus de 10 000 kg.m⁻³, et/ou qui sont à haute température, typiquement dans la plage des températures de fusion des métaux traités, mis en forme ou utilisés sous forme liquide.

Au final, un détecteur selon l'invention proposée permet de dépasser les limitations identifiées des dispositifs de l'art antérieur et présente de nombreux avantages parmi lesquels :
- un traitement des signaux qu'il produit, très simple comparativement aux débitmètres existants, et nettement moins complexe que les algorithmes de reconstruction nécessaires aux DDF selon l'état de l'art et aux méthodes de mesure tomographique ;
- la possibilité d'un positionnement au sein de l'écoulement à caractériser dans la zone à étudier.

D'autre avantages et caractéristiques ressortiront mieux à la lecture de la description détaillée, faite à titre illustratif et non limitatif, en référence aux figures suivantes.

### Brève description des dessins

[Fig 1] la figure 1 est une vue schématique de côté d'un Débitmètre à Distorsion de Flux (DDF) selon l'état de l'art, à une bobine réceptrice (secondaire).
[Fig 2] la figure 2 est une vue schématique de côté d'un DDF selon l'état de l'art, à deux bobines réceptrices (secondaires).
[Fig 2A] la figure 2A est une vue en coupe longitudinale de la figure 2.
[Fig 3] la figure 3 reprend la figure 1 et illustre le développement de densités de courants induits sous l'action du champ magnétique externe en l'absence de vitesse d'écoulement.
[Fig 4] la figure 4 reprend la figure 2 et illustre le développement de densités de courants induits sous l'action du champ magnétique externe en l'absence de vitesse d'écoulement.
[Fig 5A], [Fig 5B] les figures 5A et 5B reprennent la figure let illustrent le développement de densités de courants induits sous l'action du champ magnétique externe en présence d'une vitesse d'écoulement.
[Fig 6] la figure 6 reprend la figure 2 et illustre le développement de densités de courants induits sous l'action du champ magnétique externe en présence d'une vitesse d'écoulement.
[Fig 7A], [Fig 7B] les figures 7A et 7B sont des représentations de simulations numériques du champ magnétique autour d'un DDF selon l'état de l'art, respectivement en l'absence et en présence de vitesse d'écoulement de fluide conducteur de l'électricité.
[Fig 8] la figure 8 reprend la figure 1 et illustre la tension électrique aux bornes de la bobine réceptrice du DDF selon l'état de l'art.
[Fig 9] la figure 9 reprend la figure 2 et illustre d'une part un couplage électrique préférentiel des bobines réceptrices en anti-série ainsi que les tensions électriques aux bornes des bobines la tension finale relevée aux bornes du DDF selon l'état de l'art.
[Fig 10] la figure 10 est une reproduction reprographique d'un DDF selon l'état de l'art tel qu'agencé en interne dans un tube d'implantation pour la mesure d'une vitesse monodimensionnelle d'un fluide F en écoulement.
[Fig 11] la figure 11 est une vue schématique de côté d'un transducteur électromagnétique d'un détecteur de variation de vitesse selon l'invention, à une bobine primaire alimentée en courant continu et une bobine réceptrice (secondaire).
[Fig 12] la figure 12 est une vue schématique de côté d'un transducteur électromagnétique d'un détecteur de variation de vitesse selon l'invention, à aimant permanent et une bobine réceptrice (secondaire).
[Fig 13] la figure 13 est une vue schématique d'un circuit détecteur enveloppe pour un détecteur selon l'invention.
[Fig 14] la figure 14 est une vue schématique d'un double circuit détecteur enveloppe pour un détecteur selon l'invention.

### Description détaillée

Dans l'ensemble de la présente demande, les termes « amont » et « aval » sont à comprendre par référence au sens de l'écoulement d'un fluide autour du transducteur suivant l'axe Z.

Les figures 1 à 10 ont déjà été décrites en préambule. Elles ne seront donc pas détaillées par la suite.

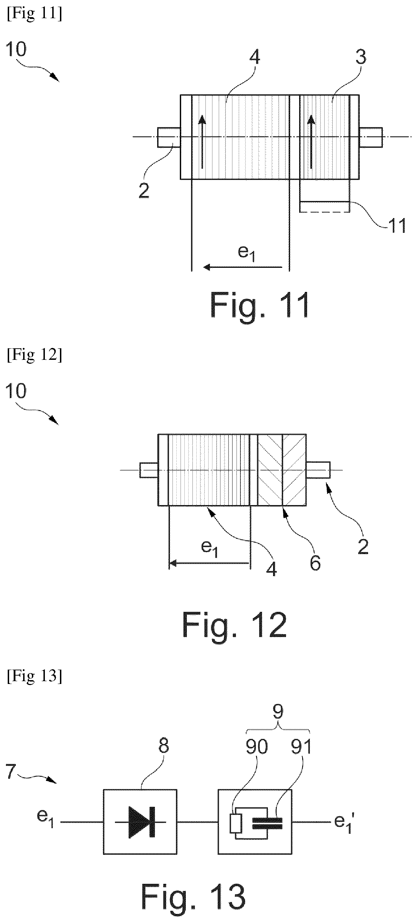

On a représenté à la figure 11, un transducteur électromagnétique 10 d'un détecteur selon l'invention, destiné à mesurer la variation de vitesse d'un écoulement d'un fluide électriquement conducteur.

Le transducteur 10 est axisymétrique d'axe central X et typiquement constitué d'un noyau à haute perméabilité magnétique 2, d'une bobine électrique émettrice, dite primaire 3, et d'une bobine électrique réceptrice, dite secondaire 4.

Le noyau 2 est formé d'un tube s'étendant selon l'axe central X.

Les bobines primaire 3 et secondaire 4 sont enroulées autour du tube 2.

Une alternative au transducteur de la figure 11 est montrée à la figure 12 : en lieu et place d'une bobine primaire à alimenter en courant continu, un aimant permanent 6 peut être agencé autour du noyau 2, adjacent à la bobine secondaire 4.

Un circuit détecteur d'enveloppe 7 est relié aux bornes de la bobine secondaire 4. Comme illustré à la figure 13, un tel circuit 7 est constitué d'une diode 8 reliée en série à une charge 9 constituée d'une résistance 90 en parallèle avec un condensateur 91.

Le circuit détecteur d'enveloppe 7 relié à un dispositif électronique à détection par dépassement de seuil, non représenté. Il peut s'agir d'une bascule de Schmitt aussi couramment appelé trigger de Schmitt.

Le fonctionnement du détecteur à transducteur électromagnétique 10 et circuit détecteur d'enveloppe 7 est maintenant expliqué.

En cas de variation de vitesse du fluide environnant le transducteur 10, la bobine réceptrice 4 est le siège d'une force électromotrice induite provoquée par la variation du flux magnétique provenant soit de la bobine primaire 3 alimentée en courant, soit de l'aimant permanent 6.

L'amplitude du signal de tension e₁ délivré par la bobine réceptrice 4 dépend de l'amplitude de la variation de vitesse. La composante de vitesse à laquelle le détecteur est sensible est celle qui est dans parallèle à l'axe central (Z).

Le signe du signal du détecteur renseigne sur le fait que la variation de vitesse est positive ou négative (accroissement ou diminution de la vitesse).

La bobine 4 délivre donc une tension e₁ qui est redressée par la diode 8 et charge le condensateur 91. La résistance 90 permet au condensateur de se décharger progressivement de manière à limiter dans un temps souhaité la durée d'existence d'une tension e'₁, qui est l'image de l'enveloppe du signal résultant des valeurs de e₁ dans le temps. Ces valeurs e'₁ sont détectées par la bascule de Schmitt.

Ainsi, on détecte de manière très simple et on peut mémoriser provisoirement l'existence d'une tension e₁, selon une durée qui est fonction de la capacité du condensateur 91 et de la résistance ohmique de la résistance 90.

Avec un seul circuit d'enveloppe 7 selon la figure 13, on obtient uniquement l'accroissement ou la réduction de vitesse du fluide en écoulement autour du transducteur.

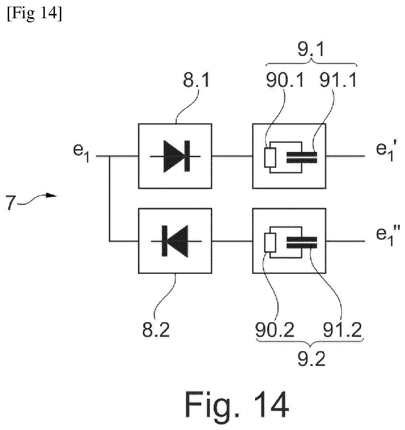

Une variante de double circuit d'enveloppe 7 est illustré à la figure 14 : deux circuits détecteurs d'enveloppe 7 sont ici reliés en parallèle électrique à la bobine réceptrice 4. Chacun des deux circuits est constitué d'une diode 8.1 ; 8.2 reliée en série à une charge 9.1 ; 9.2 constituée d'une résistance 90.1 ; 90.2 en parallèle avec un condensateur 91.1 ; 91.2.

La diode 8.1 de l'un des deux circuits est montée en sens opposé à la diode 8.2 de l'autre des deux circuits.

Avec ce double circuit 7, on obtient une détection à la fois de l'accroissement et de la diminution de la vitesse. Les tensions e'₁ et e"₁ renseignent sur l'existence d'une variation positive, par exemple donnée par e'1 et négative, par exemple donnée par e"₁. Ces valeurs de tension e'₁, e"₁ en sortie sont détectées chacune par une bascule de Schmitt.

D'autres variantes et améliorations peuvent être envisagées sans pour autant sortir du cadre de l'invention.

### Liste des références citées

[1] : https://www.hzdr.de/db/Cms?pOid=55433&pNid=226
[2]: https://ieeexplore.ieee.org/stamp/stamp.jsp?arnumber=9768530

## Revendications

1. Détecteur de variation de vitesse d'un écoulement d'un fluide électriquement conducteur, comprenant :
- un transducteur électromagnétique (10), comprenant :
un tube cylindrique métallique (2) formant un noyau à haute perméabilité magnétique,
une bobine électrique (3), dite bobine primaire, enroulée autour du tube et destinée à être alimentée électriquement en courant continu, ou un aimant permanent agencé autour du tube,
au moins une bobine électrique (4), dite bobine réceptrice, enroulées autour du tube en étant adjacente à la bobine primaire ou à l'aimant permanent,
- au moins un circuit détecteur d'enveloppe (7) relié à la bobine réceptrice, comprenant au moins une diode (8 ; 8.1, 8.2) et d'une charge (9 ;9.1, 9.2) en série électrique avec la diode, la charge étant constituée d'un condensateur (91; 91.1, 91.2), et d'une résistance électrique (90 ; 90.1, 90.2).

2. Détecteur selon la revendication 1, comprenant un seul circuit détecteur d'enveloppe.

3. Détecteur selon la revendication 1, comprenant deux circuits détecteurs d'enveloppe en parallèle à la bobine réceptrice, la diode de l'un des deux circuits étant montée en sens opposé à la diode de l'autre des deux circuits.

4. Détecteur selon l'une des revendications précédentes, comprenant un dispositif électronique relié au(x) circuit(s) détecteur(s) d'enveloppe pour détecter le(s) seuil(s) de tension électrique (e'₁, e"₁) à la sortie du(des) condensateur(s).

5. Détecteur selon la revendication 4, le dispositif électronique étant une bascule de Schmitt.

6. Utilisation d'un détecteur selon l'une des revendications précédentes, pour la mesure de variation de vitesse d'un écoulement d'un fluide électriquement conducteur, tel qu'un métal liquide de réacteur nucléaire.

## Patentansprüche

1. Detektor zur Bestimmung der Geschwindigkeitsänderung eines elektrisch leitenden Fluidstroms, der Folgendes aufweist:
- einen elektromagnetischer Wandler (10), der Folgendes aufweist:
ein zylindrisches Metallrohr (2), das einen Kern mit hoher magnetischer Permeabilität bildet
eine elektrische Spule (3), die als Primärspule bezeichnet wird, um das Rohr gewickelt ist und dazu bestimmt ist, elektrisch mit Gleichstrom versorgt zu werden, oder einen Permanentmagnet, der um das Rohr herum angeordnet ist,
mindestens eine elektrische Spule (4), die als Empfängerspule bezeichnet wird und um das Rohr angrenzend an die Primärspule oder den Permanentmagneten gewickelt ist,
- mindestens eine mit der Empfängerspule verbundene Hüllkurven-Detektorschaltung (7), die mindestens eine Diode (8; 8,1, 8,2) und eine Last (9; 9,1, 9,2) elektrisch in Reihe mit der Diode aufweist, wobei die Last aus einem Kondensator (91; 91.1, 91.2) und einem elektrischen Widerstand (90; 90.1, 90.2) besteht.

2. Detektor nach Anspruch 1, der eine einzige Hüllkurven-Detektorschaltung aufweist.

3. Detektor nach Anspruch 1, der zwei Hüllkurven-Detektorschaltungen parallel zur Empfängerspule aufweist, wobei die Diode einer der beiden Schaltungen entgegengesetzt zur Diode der anderen der beiden Schaltungen angeordnet ist.

4. Detektor nach einem der vorhergehenden Ansprüche, der eine mit der oder den Hüllkurven-Detektorschaltung(en) verbundene elektronischen Vorrichtung zum Erfassen der elektrischen Spannungsschwelle (en) (e'₁, e"₁) am Ausgang des Kondensators oder der Kondensatoren aufweist.

5. Detektor nach Anspruch 4, wobei die elektronische Vorrichtung ein Schmitt-Trigger ist.

6. Verwendung eines Detektors nach einem der vorhergehenden Ansprüche zur Messung der Geschwindigkeitsänderung eines elektrisch leitenden Fluidstroms, wie beispielsweise eines flüssigen Metalls in einem Kernreaktor.

## Claims

1. Detector for detecting a change in velocity of a flow of an electrically conductive fluid, comprising:
- an electromagnetic transducer (10) comprising:
a metal cylindrical tube (2) forming a core having a high magnetic permeability,
an electric coil (3), called primary coil, wound around the tube and intended to be electrically powered with direct current, or a permanent magnet arranged around the tube,
at least one electric coil (4), called receiver coil, wound around the tube while being adjacent to the primary coil or to the permanent magnet,
- at least one envelope detector circuit (7) connected to the receiver coil, comprising at least one diode (8; 8.1, 8.2) and one load (9; 9.1, 9.2) electrically in series with the diode, the load being made up of a capacitor (91; 91.1, 91.2) and of an electrical resistor (90; 90.1, 90.2).

2. Detector according to Claim 1, comprising a single envelope detector circuit.

3. Detector according to Claim 1, comprising two envelope detector circuits in parallel with the receiver coil, the diode of one of the two circuits being mounted in the opposite direction to the diode of the other of the two circuits.

4. Detector according to one of the preceding claims, comprising an electronic device connected to the envelope detector circuit(s) so as to detect the voltage threshold(s) (e'₁, e"₁) at the output of the capacitor(s) .

5. Detector according to Claim 4, the electronic device being a Schmitt trigger.

6. Use of a detector according to one of the preceding claims for measuring a change in velocity of a flow of an electrically conductive fluid, such as a liquid metal of a nuclear reactor.
